(19)

**Europäisches Patentamt**
**European Patent Office**
**Office européen des brevets**

(11) **EP 3 002 776 B1**

(12) **EUROPEAN PATENT SPECIFICATION**

(45) Date of publication and mention
of the grant of the patent:
**30.11.2016 Bulletin 2016/48**

(51) Int Cl.:
***H01J 37/26*** *(2006.01)*    ***H01J 37/28*** *(2006.01)*

(21) Application number: **15183529.5**

(22) Date of filing: **02.09.2015**

(54) **METHODS AND APPARATUS FOR MEASURING ELECTRON BEAM SPOT**

VERFAHREN UND VORRICHTUNG ZUR MESSUNG EINES ELEKTRONENSTRAHLFLECKS

PROCÉDÉS ET APPAREIL DE MESURE DE POINT DE FAISCEAU D'ÉLECTRONS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.09.2014 CN 201410449770**

(43) Date of publication of application:
**06.04.2016 Bulletin 2016/14**

(73) Proprietors:
• **Peking University School of Software and
Microelectronics at Wuxi
Wuxi Jiangsu 214125 (CN)**
• **Peking University
Beijing 100871 (CN)**

(72) Inventors:
• **SHI, Guangyi
214125 Wuxi (CN)**
• **LIU, Peng
100871 Beijing (CN)**
• **ZHANG, Dacheng
100871 Beijing (CN)**
• **WANG, Wei
100871 Beijing (CN)**
• **TIAN, Dayu
100871 Beijing (CN)**

• **YANG, Fang
100871 Beijing (CN)**
• **LUO, Kui
100871 Beijing (CN)**
• **DAI, Xiaotao
100871 Beijing (CN)**
• **LI, Ting
100871 Beijing (CN)**
• **WANG, Ying
100871 Beijing (CN)**
• **LI, Jing
100871 Beijing (CN)**

(74) Representative: **Bohest AG
Holbeinstrasse 36
4051 Basel (CH)**

(56) References cited:
**WO-A1-2013/112041     JP-B2- 3 294 506**

• **BABIN S ET AL: "Fabrication of 20nm patterns
for automatic measurement of electron beam size
using BEAMETR technique",
MICROELECTRONIC ENGINEERING, ELSEVIER
PUBLISHERS BV., AMSTERDAM, NL, vol. 86, no.
4-6, 1 April 2009 (2009-04-01), pages 524-528,
XP026106207, ISSN: 0167-9317, DOI:
10.1016/J.MEE.2008.11.074 [retrieved on
2008-12-09]**

## Description

TECHNICAL FIELD

The present disclosure relates to microelectronics field, particularly to files for micro/nano fabrication, and more particularly to methods and apparatus for measuring electron beam spot in nano scale.

BACKGROUND

At present, the microelectronic technology has been developed to an order of 14 nm. According to the predication from ITRS (International Technology Roadmap for Semiconductors), the microelectronic technology node name will be 5 or 7 in 2019. The level of the microelectronics fabrication in a nano scale is critical to ensure device performance and to affect yield of end product. At present, the electronic optical apparatus in a precision of nanometers is widely used in nano device manufacturing. Electron beam direct write lithography, which has excellent and flexible nano patterning abilities, is one of the most competitive methods for realizing nanostructure in long-range order. Furthermore, in various applications including representation of structure profile, measurement of line width and analysis of components, it is widely used such as electron microscope, CD-SEM, electron spectrum analyzer and so on. The basic principle of the apparatuses as mentioned above are shown as follows: an electron beam is focused by an electron-optical system to nano scale; the beam spot is scanned through "A" surface of the sample by deflector so as to fabricate or analyses. In those apparatuses, electron beam spot size determines the resolution of the system. The measurement of beam spot size and the beam intensity distribution is an important index to check the resolution of an apparatus. A means for detecting beam spot size is usually found in electron accelerator, such as electron-positron collider, circular accelerator, synchrotron radiation source and so on. These detecting means mainly include fluorescence detector, linear scanning detector, Compton scattering sensor, laser interference detector and so on. However, these detecting means are limited as follows:

    1) The resolution of the fluorescence detector is limited by physical and chemical properties of the fluorescent agent itself and the molecule size of the fluorescent agent.
    2) Due to thermal effect caused by high-energy electron radiation, the line diameter of the linear scanning detector is few microns so as to enhance mechanical strength and extend operation life, which limits the resolution.
    3) The principle of Compton scattering is similar to that of laser interference fringe scattering. The later has a higher resolution, which still limited by wavelength of the laser.

These detectors are design for electrons with kinetic energy in MeV and beam spot size in micro or nano scale. For the manufacturing and testing system in micro/nano fabrication, the kinetic energy of electron beam is usually less than or equal to 100keV and the beam spot size is no more than 10 nm so the detectors that mentioned above can't meet the requirement of these applications.

SUMMARY

An object of the present disclosure is to provide methods and apparatus for measuring an electron beam spot in nano scale.
According to one aspect of the present disclosure, there is provided a method for measuring electron beam spot, comprising: depositing a conductive film on "A" surface of a first substrate to constitute a supporting film; forming a detecting channel on "B" surface of the first substrate opposite to the "A" surface, in which the detecting channel gets through the first substrate and gets to the reverse surface of the supporting film, the width of the detecting channel is W; applying photoresist on the supporting film; forming a back cavity structure in a second substrate which is independently processed, the back cavity structure configured to absorb scattered electrons; fixing "C" surface of the second substrate which is the entrance side of the back cavity structure to the "A" surface of the first substrate and aligning the detecting channel with the entrance of the back cavity structure; scanning the electron beam to be measured across the detecting channel in a path angle of Θ in one direction to expose the photoresist in a backwards direction, wherein the path angle is an inclination angle formed by the scanning direction of the electron beam and the lengthwise direction of the detecting channel; developing the photoresist and measuring pattern length L of the photoresist along the scanning direction; and calculating the beam spot diameter d of the electron beam according to the following formula:

$$d = L \cdot \tan\theta - W / \cos\theta.$$

Preferably, after applying photoresist, the method further comprises applying a protective layer on the photoresist after applying the photoresist and removing the protective layer before developing the photoresist.
According to another aspect of the present disclosure, there is provided an apparatus for measuring an electron beam spot, comprising: a first substrate, on "A" surface on which a conductive film is deposited to constitute a supporting film; a detecting channel formed on the film deposited on "B" surface of the first substrate opposite to the "A" surface, in which the detecting channel get through the first substrate and gets to reverse surface of the supporting film, the width of the detecting channel is W; photoresist applied on the supporting film; a second substrate in which a back cavity structure is formed independently, the back cavity structure configured to absorb scattered electrons; fixing and alignment means for fixing "C" surface of the second substrate which is the entrance side of the back cavity structure to the "A" surface of the first substrate and for aligning the detecting channel with the entrance of the back cavity structure; scanning angle control means for scanning the electron beam to be measured across the detecting channel in a path angle of $\Theta$ in one direction to expose the photoresist in a backwards direction, wherein the path angle is an inclination angle formed by the scanning direction of the electron beam and the lengthwise direction of the detecting channel; measuring means for measuring pattern length L of the photoresist along the scanning direction after developing the photoresist; and the beam spot diameter d of the electron beam is calculated according to the following formula: $d = L \cdot \tan \theta - W / \cos \theta$.

Preferably, the first substrate further comprises a protective layer applied on the photoresist after the photoresist is applied. The protective layer is removed before the photoresist is developed.

Preferably, the back cavity structure is a through via structure or a non-through structure.

Preferably, the supporting film is a conductive film with small electron scattering cross section. For example, the supporting film is an aluminum film.

Preferably, the size of the back cavity at its side with a small size is larger than or equal to that of the detecting channel.

The precision of the beam spot pattern may be further improved by employing a conductive supporting film to reduce the charging effect during exposure. The process may be flexible and may be not limited by the fabrication process of the supporting film, or by employing a back cavity which is independently processed. The influence of the back scattered electrons by the substrate during the exposure may be totally avoided by the back exposure of the photoresist. The electrons with higher energy have smaller electron scattering cross section. The electron beam firstly passes through a material of the film with smaller scattering cross section so that the electron beam maintains its original property after passing through the supporting film and the boundary of the photoresist after exposure reflects the energy distribution and spatial distribution of the electrons faithfully. The electron beam passes through a suspended photoresist and enters into the back cavity structure, and most of the electrons are scattered within the back cavity and are absorbed by the cavity wall. Thus, the possibility of the electrons returning to the photoresist is reduced. The electrons scattered from the back cavity is further absorbed by the protective layer which also protected the photoresist from being mechanically damaged when fixing the first substrate and the device on the second substrate.

BRIEF DESCRIPTION OF THE DRAWINGS

Fig. 1 shows basic principle of one method and apparatus for measuring electron beam spot in a nano scale according to the present disclosure.

Fig. 2 shows basic principle of another method and apparatus for measuring electron beam spot in nano scale according to the present disclosure.

Fig. 3 shows a schematic view of operation detail..

Fig. 4 shows a schematic view of the method for evaluating a size of electron beam spot by measuring a patterned photoresist.

Fig. 5(a) - fig. 5(b) show schematic views of the other through viaback cavity structure.

Fig. 6(a) - fig. 6(b) show schematic views of non-through back cavity structure.

Fig. 7 shows a flowchart of a method for measuring electron beam spotaccording to one embodiment of the present disclosure.

Fig. 8 shows a flowchart of a method for measuring electron beam spot according to another embodiment of the present disclosure.

Fig. 9 shows a flowchart of a method for measuring electron beam spot according to a further embodiment of the present disclosure.

Fig. 10 shows a device structure for measuring the beam spot.

Fig. 11(a) - fig. 11(f) show a schematic view of the method for measuring electron beam spot according to the embodiment of the present disclosure in conjunction with the device structure.

Fig. 12(a) - fig. 12(g) show a schematic view of the method for measuring electron beam spot according to the embodiment of the present disclosure in conjunction with the device structure.

DETAILED DESCRIPTION

The present disclosure will be described in more details below with reference to the accompanying drawings. In the respective drawings, like reference numerals denote like elements. The figures are not drawn to scale, for the sake of clarity. For simplicity, the structure having been subject to several relevant process steps may be shown in one figure.

Some specific details may be illustrated below, such as structure, material, size, process and technique for the device so as to further understand the present disclosure. It should be understood for those skilled in the art that the present invention may be implemented without these specific details.

It should be understood that when one layer or region is referred to as being "above" or "on" another layer or region in the description of device structure, it can be directly above or on the other layer or region, or other layers or regions may be intervened there between. Moreover, if the device in the figures is turned over, the layer or region will be "under" or "below" the other layer or region. In order to illustrate a situation in which one layer or region is directly positioned to the other layer or region, one layer is referred to as being "directly on" or "on and adjacent to" in the present description.

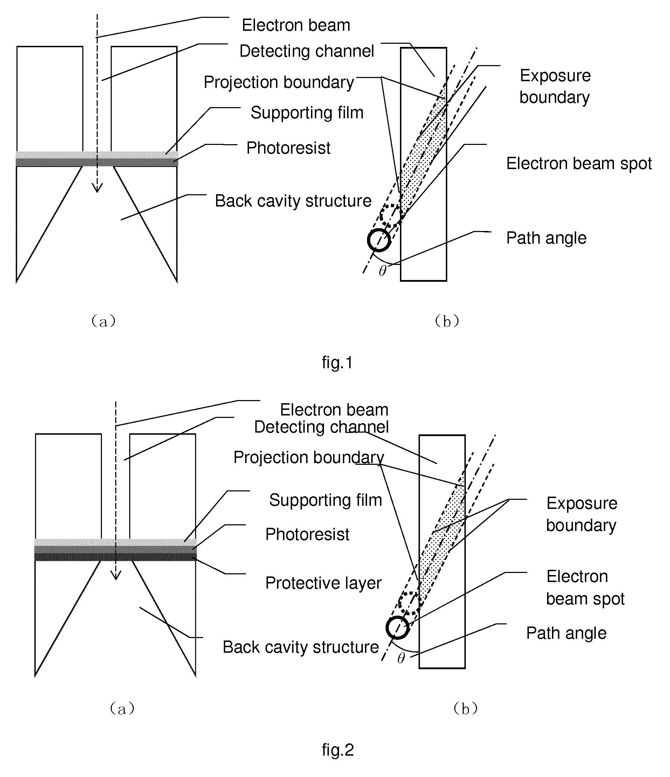

Fig. 1 shows basic principle of one method and apparatus for measuring electron beam spot in nano scale according to the present disclosure. As shown in fig. 1(a), photoresist is suspended at the entrance of a back cavity structure by utilizing a conductive supporting film. When being scanned, an electron beam to be measured passes through a detecting channel, gets through a conductive supporting film with a small scattering cross section and then the photoresist, and enters into the back cavity structure. Benefiting from a conductive property of the supporting film, the electrons would not be accumulated around the exposure pattern and negative influence of the charging effect on the precision of the beam spot pattern is eliminated. The transmitted electrons are scattered in the back cavity structure and most of the scattered electrons are captured by the back cavity structure and can't return to the photoresist. The energy of the incident electrons cause cross linking (delinking) reaction of photoresist molecules and the transmitted electrons can't return to the photoresist so as to form an exposure boundary with a higher contrast, as shown in fig. 1(b).

Fig. 2 shows basic principle of another method and apparatus for measuring electron beam spot in nano scale according to the present disclosure. As shown in fig. 2(a), photoresist is suspended at the entrance of a back cavity structure by utilizing a conductive supporting film. When being scanned, an electron beam to be measured passes through a detecting channel, gets through a conductive supporting film with small scattering cross section, the photoresist, and a protective layer, and then enters into the back cavity structure. Benefiting from conductive property of the supporting film, the electrons would not be accumulated around the exposure pattern and negative influence of the charging effect on the precision of the beam spot pattern is eliminated. The structure as shown in fig. 2 is similar to that of fig. 1, except for that the protective layer is further applied on the other side of the photoresist opposite to the supporting film. The transmitted electrons are scattered in the back cavity structure and most of the scattered electrons are captured by the back cavity structure and can't return to the photoresist. The electrons which are not absorbed by the back cavity structure are further absorbed by the protective layer and can't return to the photoresist. That is to say, a combination of the back cavity structure and the protective layer constitutes an absorbing structure for the transmitted electron beams. The energy of the incident electrons cause cross linking (delinking) reaction of photoresist molecules and most of the transmitted electrons can't return to the photoresist so as to form an exposure boundary with higher contrast, as shown in fig. 2(b).

In particularly, a suspended photoresist is manufactured firstly. Then, the suspended photoresist is exposed backwards by an electron beam and developed. The developed photoresist pattern is measured to obtain beam spot size of the electron beam. The photoresist as mentioned above is supported by a conductive film having certain mechanical strength. Material of such a film has smaller cross section of the scattered electrons and lower secondary electron production. Thus, the electron beam transmitted through the conductive supporting film maintains its original property and the exposure boundary formed in the photoresist reflects the energy distribution and spatial distribution of the electrons faithfully. Furthermore, the conductivity of the supporting film may eliminate charging effect around the exposure pattern. Secondly, the electron beam transmits through the suspended photoresist and enters into the absorbing structure. The absorbing structure reduces the possibility of the electrons returning to the photoresist. In particularly, the absorbing structure may be only the back cavity structure or the combination of the back cavity structure and the protective layer. The back cavity structure is a hollow cavity which is much larger than that of the detecting channel, in which most of the electrons are scattered continuously within the back cavity and are absorbed by the cavity wall without returning to the photoresist so as to form a sharp exposure boundary. The cross section of the back cavity structure may be an approximate round shape, a wedge shape or a rectangular shape. The size of the back cavity with an approximate round shape and a wedge shape at the entrance side with a small size is larger than or equal to that of the detecting channel. The size of the back cavity with a rectangular shape at the entrance size is larger than that of the detecting channel. The formed back cavity is much larger than that of the opening of the detecting channel. The protective layer is one layer of material which absorbs the electrons. The back cavity structure may be a through via or non-through via back cavity which is independently formed in the second substrate. However, the size of the cavity should be much larger than that of the detecting channel so as to absorb the scattered electrons. The means for independently forming the cavity refers to that the process for forming the back cavity is totally separated from that of the supporting film and is an independent machining process. In addition, a plurality of back cavities with various shapes and different sizes may be prepared beforehand and an appropriate back cavity may be selected according to the electron beam to be measured. The protective layer comprises LOL2000, AR-PC5000/90, and polymer such as polyimide, polyvinyl alcohol and so on. The protective layer may be other organic film compatible with the process of the selected photoresist. A portion of the electrons transmitted through the photoresist are absorbed by the protective layer when it firstly passes through the protective layer and the electrons scattered by the back cavity may be further absorbed by the protective layer, so that most of the transmitted electrons would not return to the photoresist.

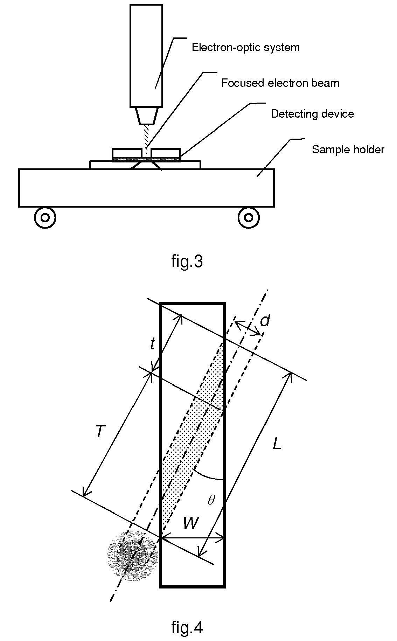

After the first substrate applied with the conductive supporting film and the photoresist (optional protective layer) and the second substrate in which a back cavity structure is formed are fixed together, the measuring method of the present disclosure may be implemented. Firstly, a beam spot pattern of an electron beam is collected. In particularly, a scanning angle control means of the scanning apparatus scans the electron beam across the detecting channel in a path angle of θ in one direction to expose the photoresist, as shown in fig. 1(b) and fig. 2(b). Aspect ratio of the detecting channel is high enough to form a slim channel penetrating through the first substrate between the detecting channel and the photoresist, so that most of the scattered electrons generated at edges of the detecting channel is absorbed by sidewalls and the electron beam is shielded by edges of the detecting channel to form a projection boundary in the photoresist. The formed slim channel may play a role of collimation. The shadow portion surrounded by the projection boundary and the exposure boundary is the beam spot pattern. Furthermore, the photoresist is exposed along a backward direction so as to completely avoid the influence of back scattered electrons; meanwhile, the electron beam with high energy may firstly pass through the supporting film and cause a low forward scattering effect. Fig. 3 shows a schematic view of operation detail. A detecting device is positioned on a sample holder of the electron beam exposing and scanning device. The electron beam to be measured is scanned over the detecting channel in a manner as mentioned above so as to expose and develop the photoresist to get the photoresist pattern as shown in fig. 4.

Fig. 4 shows a schematic view of the method for measuring a size of electron beam spot by a patterned photoresist. As shown in fig. 4, the path angle u and a width W of the detecting channel are known, so the distance T by which the beam spot scans across the detecting channel is as follows:

$$T = W/\sin\theta,$$

The beam spot diameter d is as follows:

$$d = t * \tan\theta,$$

The length of the beam spot pattern is measured to be L, where $L = T + t = W/\sin\theta + d/\tan\theta$.

Thus, the beam spot diameter d is derived as follows:

$$d = L \cdot \tan\theta - W/\cos\theta,$$

in which W is a width of the detecting channel. Since the detecting channel is obtained by exposure and etching, the width of the detecting channel is known or can be measured. For example, the width of the detecting channel is about 0.5 - 1.5 μm. The path angle is an angle formed by the scanning direction of the electron beam and the length direction to the detecting channel, and the angle ranges within 0 - 90°. In addition, a value of the angle may be determined during exposure by an electron beam exposure apparatus as shown in fig. 3. L is a length of the beam spot pattern in the detecting channel along the scanning direction of the electron beam spot. In case of reduced path angle, the size of the beam spot at projection boundaries as shown in fig. 1(b) and fig. 2(b) is enlarged so as to precisely measure the electron beam spot in nano scale.

For example, if an existing apparatus (e.g. an industrial CD-SEM with a resolution of 1.8 nm) is utilized to measure the length of the beam spot pattern, when the path angle is about 5.5°, the precision the beam spot size obtained by the present method is about 0.18 nm, which meets the measuring requirement of the electron beam spot in nano scale.

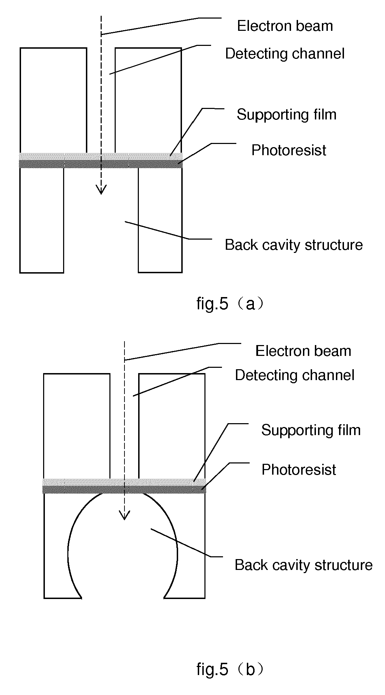

In particularly, the back cavity structure may be a through via structure which is independently formed in the second substrate. As shown in fig. 1(a) and 2(a), the cross section of the back cavity structure is a wedge shape. Furthermore, the cross section of the back cavity structure may be an approximate round shape or a rectangular shape, which are shown in fig. 5(a) and 5(b), respectively.

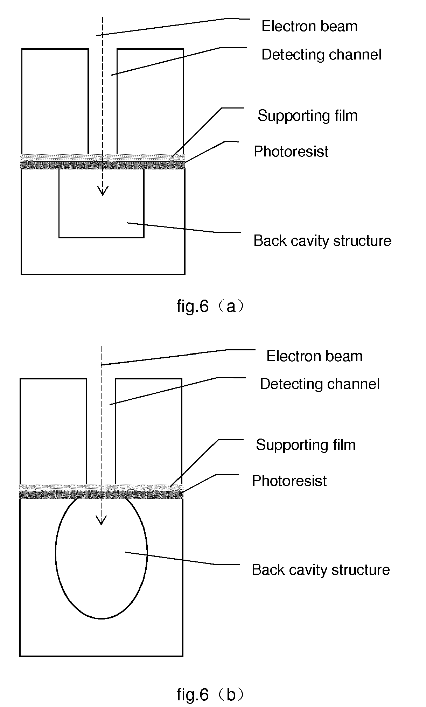

The back cavity structure may also be a non-through structure which is independently formed in the second substrate. Fig. 6(a) - 6(b) show non-through back cavity structure having cross section of a rectangular shape or an approximate round shape, respectively.

In particularly, the back cavity structure having cross section of an approximate round shape, a wedge shape or a rectangular shape is implemented by a wet etching or dry etching process from the "D" surface of the second substrate and get through to the "C" surface. Alternatively, the back cavity structure having cross section of an approximate round shape or a rectangular shape is implemented by a wet etching or dry etching process directly from the "C" surface of the second substrate and is formed as a non-through back cavity structure.

In addition, the size of the back cavity with an approximate round shape and a wedge shape at the entrance side with a small size is larger than or equal to that of the detecting channel. The size of the back cavity with a rectangular shape at the entrance size is larger than that of the detecting channel, and the formed back cavity is much larger than that of the opening of the detecting channel.

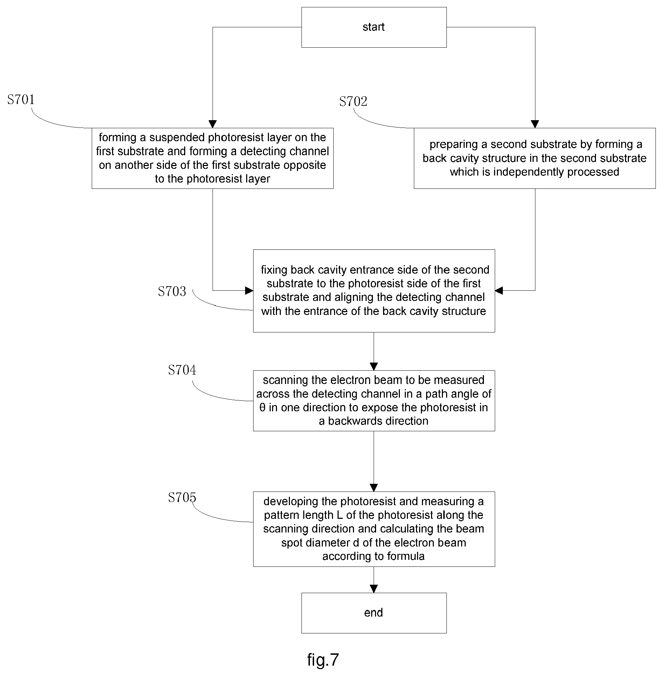

A particular embodiment of the present disclosure will be illustrated in detail in connection with fig. 1-6(b) and by reference to fig. 7. Fig. 7 shows a flowchart of the method for measuring electron beam spot according to one embodiment of the present disclosure. As shown in fig. 7, the method for measuring electron beam spot comprises the following step of: preparing a first substrate by forming a suspended photoresist layer on the first substrate and forming a detecting channel on another side of the first substrate opposite to the photoresist layer (S701); preparing a second substrate by forming a back cavity structure in the second substrate which is independently processed (S702); fixing back cavity entrance side of the second substrate to the photoresist side of the first substrate and aligning the detecting channel with the entrance of the back cavity structure (S703); scanning the electron beam to be measured across the detecting channel in a path angle of θ in one direction to expose the photoresist in a backwards direction (S704), wherein the path angle is an inclination angle formed by the scanning direction of the electron beam and the lengthwise direction of the detecting channel; developing the photoresist and measuring a pattern length L of the photoresist along the scanning direction and calculating the beam spot diameter d of the electron beam according to the following formula:

$$d = L \cdot \tan \theta - W / \cos \theta \ (S705).$$

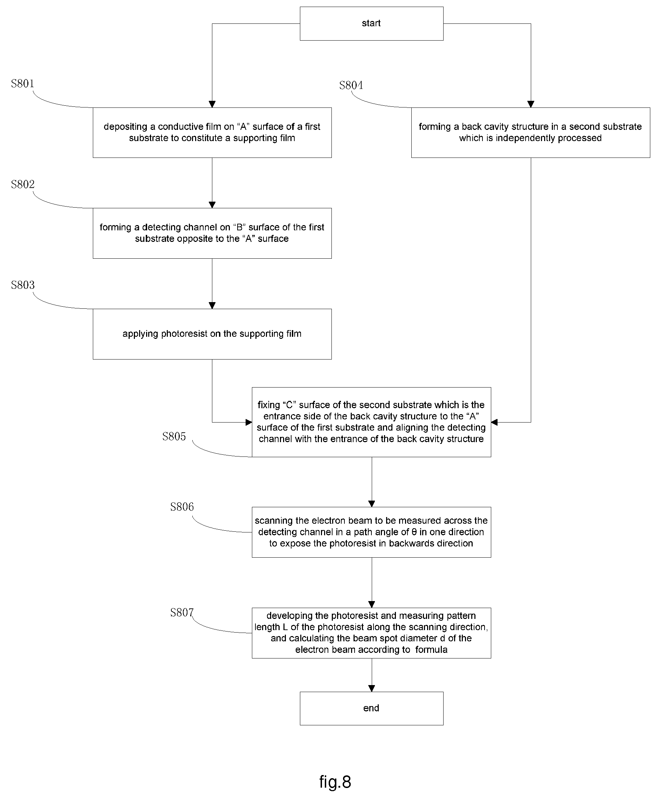

Fig. 8 shows a flowchart of a method for measuring electron beam spot according to another embodiment of the present disclosure. As shown in fig. 8, the method for measuring electron beam spot comprises the following steps of: depositing a conductive film on "A" surface of a first substrate to constitute a supporting film (S801); forming a detecting channel on "B" surface of the first substrate opposite to the "A" surface (S802), in which the detecting channel gets through the first substrate and gets to a reverse surface of the supporting film, and the width of the detecting channel is W; applying photoresist on the supporting film (S803); forming a back cavity structure in a second substrate which is independently processed (S804); fixing "C" surface of the second substrate which is the entrance side of the back cavity structure to the "A" surface of the first substrate and aligning the detecting channel with the entrance of the back cavity structure (S805); scanning the electron beam to be measured across the detecting channel in a path angle of θ in one direction to expose the photoresist in backwards direction (S806), wherein the path angle is an inclination angle formed by the scanning direction of the electron beam and the lengthwise direction of the detecting channel; developing the photoresist and measuring pattern length L of the photoresist along the scanning direction, and calculating the beam spot diameter d of the electron beam according to the following formula: $d = L \cdot \tan \theta - W / \cos \theta$ (S807).

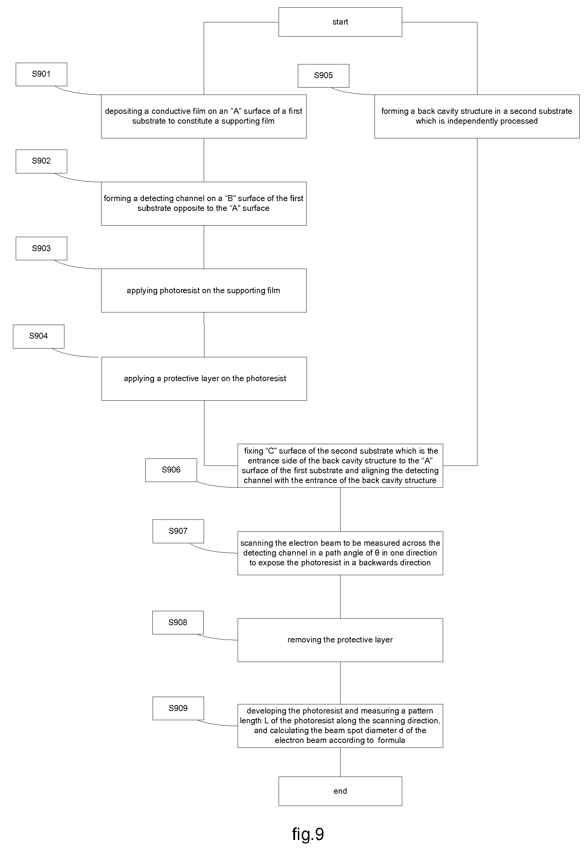

Fig. 9 shows a flowchart of a method for measuring electron beam spot according to a further embodiment of the present disclosure. As shown in fig. 9, the method for measuring electron beam spot comprises the following steps of: depositing a conductive film on an "A" surface of a first substrate to constitute a supporting film (S901); forming a detecting channel on a "B" surface of the first substrate opposite to the "A" surface (S902), in which the detecting channel gets through the first substrate and gets to a reverse surface of the supporting film, the width of the detecting channel is W; applying photoresist on the supporting film (S903); applying a protective layer on the photoresist (S904); forming a back cavity structure in a second substrate which is independently processed (S905); fixing "C" surface of the second substrate which is the entrance side of the back cavity structure to the "A" surface of the first substrate and aligning the detecting channel with the entrance of the back cavity structure (S906); scanning the electron beam to be measured across the detecting channel in a path angle of θ in one direction to expose the photoresist in a backwards direction (S907), wherein the path angle is an inclination angle formed by the scanning direction of the electron beam and the lengthwise direction of the detecting channel; removing the protective layer (S908); developing the photoresist and measuring a pattern length L of the photoresist along the scanning direction, and calculating the beam spot diameter d of the electron beam according to the following formula: $d = L \cdot \tan \theta - W / \cos \theta$ (S909).

The difference between the embodiments shown in fig. 9 and fig. 8 is that fig. 9 further comprises a step of applying a protective layer on the photoresist after the photoresist is applied and further comprises a step of removing the protective layer before the photoresist is developed. The protective layer may be constituted of LOL2000, AR-PC5000/90, polymer such as polyimide, polyvinyl alcohol, and the like. The protective layer and the back cavity structure constitute an absorbing structure for absorbing most of the scattered electrons. Furthermore, the protective layer may protect the photoresist from being damaged when the first and second substrates are fixed.

In addition, in the embodiments as shown in fig. 1 - 9, the cross sections of the back cavity structure may be an appropriate round shape, a wedge shape or a rectangular shape. The size of the back cavity with an approximate round shape and a wedge shape at the entrance side with a small size is larger than or equal to that of the detecting channel. The size of the back cavity with a rectangular shape at the entrance side is larger than that of the detecting channel, and the formed back cavity is much larger than that of the opening of the detecting channel. The back cavity structure having cross section of approximate round shape, a wedge shape or a rectangular shape is implemented by a wet etching or dry etching process from the "D" surface of the second substrate and gets through to the "C" surface. Alternatively, the back cavity structure having cross section of an approximate round shape or a rectangular shape is implemented by a wet etching or dry etching process directly from the C surface of the second substrate and is formed as a non-through back cavity structure. The supporting film is a conductive film having a smaller scattering cross section for the measured electron. The supporting film is an aluminum film or a silicon film having a thickness less than 50 nm, in which for the silicon film, a $Si/SiO_2$ is firstly deposited and then the $SiO_2$ is removed after the detecting channel is accomplished.

Furthermore, in the embodiments as shown in figures 1-9, the fixing comprises a mechanical fixing or a glued fixing. The fixing may be any fixing means which is well known for those skilled in the art, as long as the fixing means may fix the two substrates together and may easily separate the two substrates after exposure and development.

Furthermore, in the embodiments as shown in figures 1-9, the detecting channel may be manufactured in a shape of slim strip and a plurality of times of scanning, exposure, measurement and calculation are done for the detecting channel with a shape of slim strip which is separated from each other along the lengthwise direction. The electron beam spot sizes are averaged to get a more reliable result.

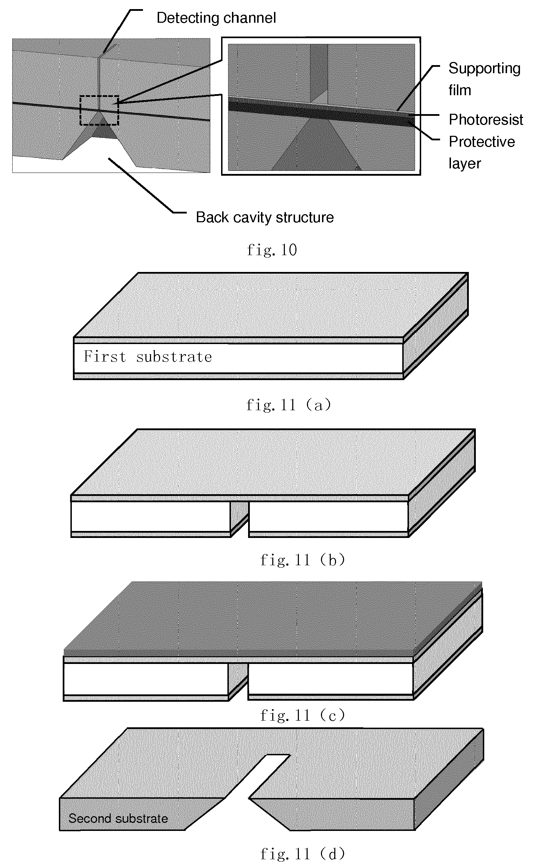

Fig. 10 shows a device structure for measuring the beam spot. The through via back cavity structure with a wedge shape is taken as an example for illustration. It should be understood for those skilled in the art that other back cavity structures of the present disclosure may be utilized. As shown in fig. 10, the device comprises a first substrate and a second substrate including the back cavity structure. A photoresist is attached on the first substrate by a supporting film. An optional protective layer may be used to protect the photoresist and further absorb the scattered electrons. A well-known silicon-based MEMS process may be utilized to manufacture the detecting device, thereby implementing the method for measuring size of the electron beam spot according to the present disclosure.

Fig. 11(a) - fig. 11(f) shows a schematic view of the method for measuring electron beam spot according to the embodiment of the present disclosure in conjunction with the device structure.

As shown in fig. 11(a), the first substrate is preprocessed by cleaning and a film is deposited on the first substrate at both sides. For example, the present embodiment utilizes a monocrystalline silicon substrate having a thickness $\geq 400 \mu m$ as the first substrate. Then, an aluminum film having a thickness < 50 nm is deposited on both sides of the result first substrate by PVD. One of the films deposited at both sides may function as a supporting film for the subsequent photoresist, and the other one of the films deposited at both sides may function as a hard mask for manufacturing the subsequent detecting channel. Actually, as long as the first substrate is etched to get through to form a detecting channel with a sidewall which is steep enough, it is not necessary to deposit the films at both sides. It is possible to deposit the supporting film for the photoresist at one side. The supporting film is an aluminum film or a silicon film having a thickness less than 50 nm, in which for the silicon film, a $Si/SiO_2$ is firstly deposited and then the $SiO_2$ is removed after the detecting channel is accomplished.

As shown in fig. 11(b), a detecting channel with a width of 1 $\mu m$ is formed on "B" surface of the first substrate by UV lithography and etching to get through. An aluminum supporting film has been already formed on "A" surface of the first substrate.

As shown in fig. 11 (c), photoresist for electron beam exposure is applied on the supporting film on the "A" surface of the first substrate. The photoresist for electron beam exposure has a thickness $\geq 20$ nm , and is pre-bake at about 85°C for about 1 minute. The pre-bake may be done by a hot plate at about 85°C or may be previously baked in an oven.

As shown in fig. 11(d), wet etching process by KOH solution is utilized to etching the second substrate from the back surface ("D" surface) to be got through and to form back cavity entrance at the front surface ("C" surface) of the second substrate (in which the entrance may cover the whole detecting channel). Alternatively, the etching may be directly started from the "C" surface of the second substrate to form the back cavity. Fig 11(d) shows a back cavity structure with a wedge shape which is formed by etching and getting through from the "D" surface. However, the embodiments of the present disclosure may be implemented by utilizing a through-via back cavity structure with an approximate round shape, a wedge shape or a rectangular shape or a non-through back cavity structure with an approximate round shape or a rectangular shape. The size of the back cavity with an approximate round shape and a wedge shape at the entrance side with a small size is larger than or equal to that of the detecting channel, the size of the back cavity with a rectangular shape at the entrance size is larger than that of the detecting channel, and the formed back cavity is much larger than that of the opening of the detecting channel. The back cavity with an approximate round shape may be manufactured by utilizing isotropic wet etching. The back cavity with a wedge shape may be manufactured by utilizing isotropic etching of KOH. The back cavity with a rectangular shape may be manufactured by utilizing anisotropic dry etching.

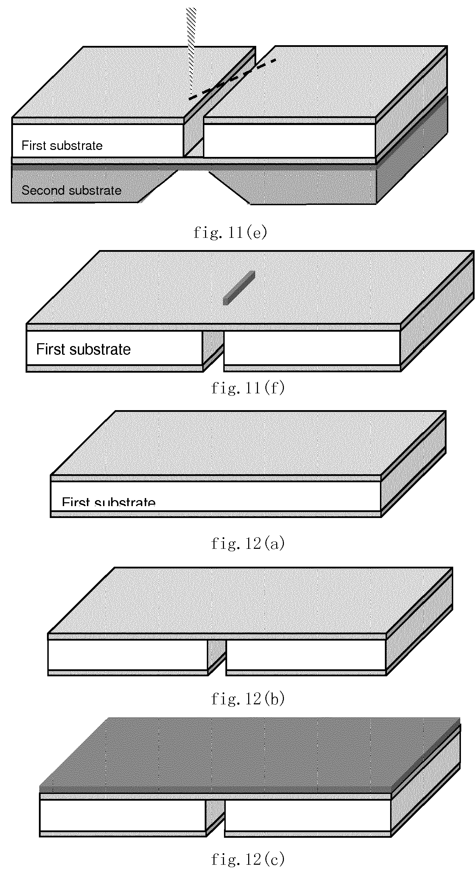

As shown in fig. 11(e), the first substrate is turned so that the "A" surface of the first substrate is downwards and is fixed to the second substrate. Furthermore, the detecting channel is aligned with entrance of the back cavity. The fixing comprises a mechanical fixing or a glued fixing, as long as a relative portion of the two substrates will not move relatively during scanning and exposure of the electron beam. Then, the electron beam to be measured is scanned across the detecting channel in single-pass line mode with path angle θ about 5° in one direction and the distance of scanning covers the width of the detecting channel.

As shown in fig. 11(f), an exposure pattern is obtained by removing the second substrate including the back cavity structure and developing the photoresist. The width W of the exposure pattern and length of the exposure pattern along the scanning direction of the electron beam are measured and the diameter of the electron beam spot is calculated by a formula of $d = L \cdot \tan\theta - W/\cos\theta$, wherein the path angle is about 5°. For example, if the length of photoresist pattern $L$ = 11.531 μm and the width of the detecting channel W = 1 μm, the diameter of the electron beam spot is about 5.0 nm.

Fig. 12(a) - fig. 12(g) shows a schematic view of another method for measuring electron beam spot according to the embodiment of the present disclosure in conjunction with the device structure.

As shown in fig. 12(a), the first substrate is preprocessed by cleaning and a film is deposited on the first substrate at both sides. For example, the present embodiment utilizes a monocrystalline silicon substrate with thickness ≥ 400 μm as the first substrate. Then, an aluminum film with thickness less than 50 nm is deposited on both sides of the first substrate by PVD. One of the films deposited at both sides may function as a supporting film for the subsequent photoresist, and the other one of the films deposited at both sides may function as a hard mask for manufacturing the subsequent detecting channel. Actually, as long as the first substrate is etched to be got through to form a detecting channel with a vertical sidewall, it is not necessary to deposit the films at both sides. It is possible to deposit the supporting film for the photoresist at one side.

As shown in fig. 12(b), a detecting channel with a width of 1 μm is formed on "B" surface of the first substrate by UV lithography and etching to get through. An aluminum supporting film has been already formed on "A" surface of the first substrate.

As shown in fig. 12 (c), a photoresist for electron beam exposure is applied on the supporting film on the "A" surface of the first substrate. The photoresist for electron beam exposure has a thickness ≥ 20nm, and is pre-baked at about 85°C for about 1 minute. The pre-bake may be done on a hot plate at about 85°C or may be pre-baked in an oven.

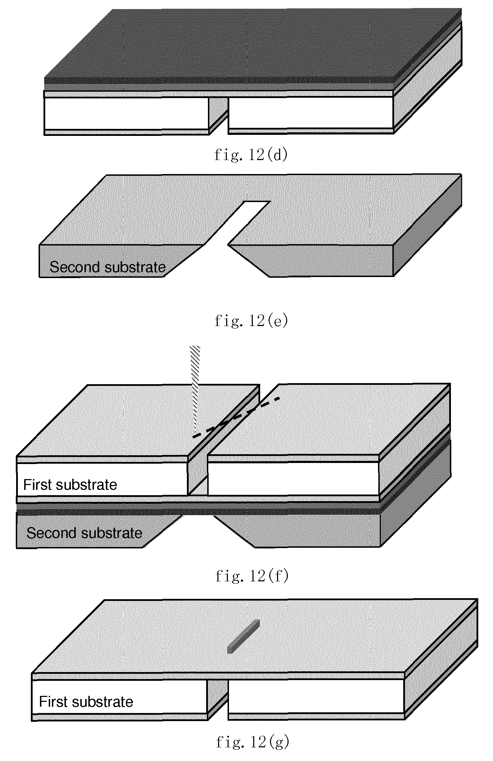

As shown in fig. 12(d), a protective layer is applied on the photoresist. The protective layer may be LOL2000 without photon/electron sensitivity. The protective layer has a thickness ≥ 200nm and is pre-baked by a hot plate at a temperature of about 75°C for about 1minute. The protective layer may further comprise AR-PC5000/90, polymer such as polyimide, polyvinyl alcohol, and so on. The protective layer may further absorb electrons scattered from the back cavity. Furthermore, the protective layer may protect the photoresist from being damaged when the first and second substrates are fixed.

As shown in fig. 12(e), a wet etching process by a KOH solution is utilized to etching the second substrate from back surface ("D" surface) to be got through and to form an entrance of the back cavity at the front surface ("C" surface) of the second substrate (in which the entrance may cover the whole detecting channel). Alternatively, the etching may be started from the "C" surface of the second substrate to form the back cavity. Fig 12(e) shows a back cavity structure with a wedge shape which is formed by etching and get through from the "D" surface. However, the embodiments of the present disclosure may be implemented by utilizing a through-via back cavity structure with an approximate round shape, a wedge shape or a rectangular shape or a non-through back cavity structure with an approximate round shape or a rectangular shape. The size of the back cavity with an approximate round shape and a wedge shape at the entrance side with a small size is larger than or equal to that of the detecting channel, the size of the back cavity with a rectangular shape at the entrance size is larger than that of the detecting channel, and the formed back cavity is much larger than that of the opening of the detecting channel. The back cavity with an approximate round shape may be manufactured by utilizing isotropic etching. The back cavity with a wedge shape may be manufactured by utilizing isotropic etching of KOH. The back cavity with a rectangular shape may be manufactured by utilizing anisotropic dry etching.

As shown in fig. 12(f), the first substrate is turned over so that the "A" surface of the first substrate is downwards and is fixed to the second substrate. Furthermore, the detecting channel is aligned with entrance of the back cavity. The fixing comprises a mechanical fixing or a glued fixing, as long as the two substrates will not move relatively during the scanning and exposure of the electron beam. Then, the electron beam to be measured is scanned across the detecting channel in single-pass line mode with path angle θ about 5° in one direction and the distance of scanning covers the width of the detecting channel.

As shown in fig. 12(g), an exposure pattern is obtained by removing the second substrate including the back cavity structure, removing the protective layer, and developing the photoresist. The width W of the exposure pattern and a length of the exposure pattern along the scanning direction of the electron beam are measured and the diameter of the electron beam spot is calculated by a formula of $d = L \cdot \tan\theta - W/\cos\theta$, wherein the path angle is about 5°. For example, if the length of photoresist pattern L = 11.531 μm and the width of the detecting channel W = 1 μm, the diameter of the electron beam spot is about 5.0 nm.

The present disclosure may utilize etching process to getting through silicon substrate to make detecting channel and utilize anisotropic etching of KOH solution to make a back cavity. The present disclosure may further utilize an aluminum film as a support to form a suspended structure of a negative electron beam photoresist with high resolution. The present disclosure may further utilize a film of polyimide as a protective layer. The precision of the beam spot pattern may be further improved by employing a conductive supporting film to reduce the charging effect during exposure. The process may be flexible and may be not limited by fabrication process of the supporting film or by employing a back cavity which is independently processed. The influence of the back scattering electrons by the substrate during exposure may be totally avoided by the backward exposure of the photoresist. The electrons with higher energy have smaller scattering cross section. The electron beam firstly passes through a film of material with smaller scattering cross section so that the electron beam maintains its original property after passing through the supporting film and the boundary of the photoresist after exposure reflects the energy distribution and spatial distribution of the electron beam faithfully. The electron beam passes through a suspended photoresist and enters into the back cavity structure, and most of the electrons are scattered within the back cavity and are absorbed by the cavity wall. Thus, the possibility of the electrons returning to the photoresist is reduced. The electrons scattered from the back cavity is further absorbed by the protective layer which also protected the photoresist from being mechanically damaged while the first substrate and the device on the second substrate are fixed.

Although the present disclosure is shown and illustrated in detail by refer to particular embodiments of the present disclosure, it should be understood for those skilled in the art that various modifications may be made in form or details without deviating from the scope of the present invention which is defined by the appended claims.

## Claims

1. A method for measuring electron beam spot, comprising:

   depositing a conductive film on "A" surface of a first substrate to constitute a supporting film; forming a detecting channel on "B" surface of the first substrate opposite to the "A" surface, in which the detecting channel gets through the first substrate and gets to the reverse surface of the supporting film, and the width of the detecting channel is W; applying photoresist on the supporting film; forming a back cavity structure in a second substrate which is independently processed, the back cavity structure configured to absorb scattered electrons; fixing "C" surface of the second substrate with an entrance side of the back cavity structure to the "A" surface of the first substrate and aligning the detecting channel with the entrance of the back cavity structure; scanning the electron beam to be measured across the detecting channel in a path angle of θ in one direction to expose the photoresist in a backwards direction, wherein the path angle is an inclination angle formed by the scanning direction of the electron beam and the lengthwise direction of the detecting channel; developing the photoresist and measuring pattern length L of the photoresist along the scanning direction; and calculating the beam spot diameter d of the electron beam according to the following formula:

$$d = L \cdot \tan \theta - W / \cos \theta.$$

2. The method according to claim 1, wherein the method further comprises applying a protective layer on the photoresist after applying the photoresist and removing the protective layer before developing the photoresist.

3. The method according to claim 2, wherein the protective layer comprises a polymer such as polyimide or polyvinyl alcohol.

4. The method according to anyone of claims 1 - 3, wherein the back cavity structure and the protective layer constitute an absorbing structure for absorbing most of the scattered electrons.

5. The method according to anyone of claims 1 - 4, wherein the back cavity structure is a through or non-through back cavity which is independently formed in the second substrate.

6. The method according to anyone of claims 1 - 5, wherein the cross section of the back cavity structure is an approximate round shape, a wedge shape or a rectangular shape.

7. The method according to claim 6, wherein the entrance's size of the back cavity with an approximate round shape or a wedge shape is larger than or equal to that of the detecting channel, the entrance's size of the back cavity with a rectangular shape is larger than that of the detecting channel, and the formed back cavity is much larger than that of the opening of the detecting channel.

8. The method according to claim 6 or 7, wherein the back cavity structure with an appropriate round shape, a wedge shape or a rectangular shape is formed by a corrupt or etch process from a D surface of the second substrate and gets the second substrate to the "C" surface; or the back cavity structure with an appropriate round shape or a rectangular shape is formed by a corrupt or etch process from the "C" surface of the second substrate and forms a non-through back cavity structure.

9. The method according to anyone of claims 1 - 8, wherein the supporting film is a conductive film having smaller scattering cross section for the measured electron beam.

10. The method according to anyone of claims 1 - 9, wherein the supporting film is an aluminum film or a silicon film with thickness less 50nm, and for the silicon film, a Si/SiO$_2$ is firstly deposited and then the SiO$_2$ is removed after the detecting channel is accomplished.

11. The method according to anyone of claims 1 - 10, wherein a width of the detecting channel is about 0.5 - 1.5 $\mu$m.

12. The method according to anyone of claims 1 - 11, wherein the fixing comprises a mechanical fixing or a glued fixing.

13. The method according to anyone of claims 1 - 12, wherein aspect ratio of the detecting channel is high enough to form a slim channel penetrating through the first substrate, so that most of the scattered electrons generated at the edges of the detecting channel is absorbed by sidewalls.

14. An apparatus for measuring an electron beam spot, comprising:

a first substrate, on an "A" surface of which a conductive film is deposited to constitute a supporting film; a detecting channel is formed on the film deposited on "B" surface of the first substrate opposite to the "A" surface, in which the detecting channel gets through the first substrate and gets to reverse surface of the supporting film, and the width of the detecting channel is W;
photoresist applied on the supporting film;
a second substrate in which a back cavity structure is formed independently, the back cavity structure configured to absorb scattered electrons;
fixing and alignment means for fixing "C" surface of the second substrate which is the entrance side of the back cavity to the "A" surface of the first substrate and aligning the detecting channel with the entrance of the back cavity structure;
scanning angle control means for scanning the electron beam to be measured across the detecting channel in a path angle of Θ in one direction to expose the photoresist in a backwards direction, wherein the path angle is an inclination angle formed by the scanning direction of the electron beam and the lengthwise direction of the detecting channel;
measuring means for measuring pattern length L of the photoresist along the scanning direction after developing the photoresist, and calculating the beam spot diameter d of the electron beam according to the following formula:

$$d = L \cdot \tan\theta - W / \cos\theta.$$

**Patentansprüche**

1. Verfahren zum Messen eines Elektronenstrahlpunktes, umfassend:

Auftragen einer leitenden Schicht auf eine Oberfläche "A" eines ersten Substrats, um eine tragende Schicht zu bilden;
Ausbilden eines detektierenden Kanals auf einer Oberfläche "B" des ersten Substrats gegenüber der Oberfläche "A", wobei der detektierende Kanal durch das erste Substrat verläuft und zur Rückseite der tragenden Schicht verläuft und die Breite des detektierenden Kanals W ist;
Aufbringen eines Fotolacks auf die tragende Schicht;
Ausbilden einer rückseitigen Hohlraumstruktur in einem zweiten Substrat, welches eigenständig bearbeitet wird, wobei die rückseitige Hohlraumstruktur dazu geeignet ist, gestreute Elektronen zu absorbieren;
Befestigen einer Oberfläche "C" des zweiten Substrats mit einer Eingangsseite der rückseitigen Hohlraumstruktur an der Oberfläche "A" des ersten Substrats und Ausrichten des detektierenden Kanals mit dem Eingang der rückseitigen Hohlraumstruktur;
Abtasten des zu messenden Elektronenstrahls über den detektierenden Kanal in einem Pfadwinkel von θ in einer Richtung, um den Fotolack in einer Rückwärtsrichtung zu belichten, wobei der Pfadwinkel ein durch die Abtastrichtung des Elektronenstrahls und die Längsrichtung des detektierenden Kanals gebildeter Neigungswinkel ist;
Entwickeln des Fotolacks und Abmessen einer Musterlänge L des Fotolacks entlang der Abtastrichtung; und

Berechnen des Strahlpunktdurchmessers d des Elektronenstrahls gemäss der folgenden Formel:

$$d = L \cdot \tan\theta - W/\cos\theta.$$

2. Verfahren nach Anspruch 1, wobei das Verfahren des Weiteren ein Auftragen einer schützenden Schicht auf den Fotolack nach einem Auftragen des Fotolacks sowie ein Abtragen der schützenden Schicht vor einem Entwickeln des Fotolacks aufweist.

3. Verfahren nach Anspruch 2, wobei die schützende Schicht ein Polymer, wie etwa ein Polyimid oder Polyvinylalkohol, umfasst.

4. Verfahren nach einem der Ansprüche 1 bis 3, wobei die rückseitige Hohlraumstruktur und die schützende Schicht eine absorbierende Struktur zum Absorbieren der meisten der gestreuten Elektronen bildet.

5. Verfahren nach einem der Ansprüche 1 bis 4, wobei die rückseitige Hohlraumstruktur eine in dem zweiten Substrat eigenständig gebildete durchgehende oder nichtdurchgehende rückseitige Hohlraumstruktur ist.

6. Verfahren nach einem der Ansprüche 1 bis 5, wobei der Querschnitt der rückseitigen Hohlraumstruktur eine ungefähr runde Form, eine Keilform oder eine rechteckige Form hat.

7. Verfahren nach Anspruch 6, wobei die Grösse des Eingangs der rückseitigen Hohlraumstruktur mit einer ungefähr runden Form oder einer Keilform grösser oder gleich der des detektierenden Kanals ist, die Grösse des Eingangs der rückseitigen Hohlraumstruktur mit einer rechteckigen Form grösser als die des detektierenden Kanals ist und die gebildete rückseitige Hohlraumstruktur viel grösser als die Öffnung des detektierenden Kanals ist.

8. Verfahren nach Anspruch 6 oder 7, wobei die rückseitige Hohlraumstruktur mit einer geeigneten runden Form, einer Keilform oder einer rechteckigen Form durch ein Abtragungs- oder Ätzverfahren von einer Oberfläche "D" des zweiten Substrats aus gebildet wird und das zweite Substrat zur Oberfläche "C" erstrecken lässt; oder die rückseitige Hohlraumstruktur mit einer geeigneten runden Form oder einer rechteckigen Form durch ein Abtragungs- oder Ätzverfahren von der Oberfläche "C" des zweiten Substrats aus gebildet wird und eine nichtdurchgehende rückseitige Hohlraumstruktur bildet.

9. Verfahren nach einem der Ansprüche 1 bis 8, wobei die tragende Schicht eine leitende Schicht mit einem kleineren streuenden Querschnitt für den gemessenen Elektronenstrahl besitzt.

10. Verfahren nach einem der Ansprüche 1 bis 9, wobei die tragende Schicht eine Aluminiumschicht oder eine Siliziumschicht mit einer Dicke geringer als 50 nm ist und für die Siliziumschicht zuerst $Si/SiO_2$ aufgetragen und dann $SiO_2$ abgetragen wird, nachdem der detektierende Kanal fertiggestellt wurde.

11. Verfahren nach einem der Ansprüche 1 bis 10, wobei eine Breite des detektierenden Kanals ungefähr 0,5 bis 1,5 $\mu$m beträgt.

12. Verfahren nach einem der Ansprüche 1 bis 11, wobei das Befestigen ein mechanisches Befestigen oder ein klebendes Befestigen umfasst.

13. Verfahren nach einem der Ansprüche 1 bis 12, wobei das Querschnittsverhältnis des detektierenden Kanals hoch genug ist, um einen das erste Substrat durchdringenden dünnen Kanal zu bilden, so dass die meisten der an den Kanten des detektierenden Kanals generierten gestreuten Elektronen von Seitenwänden absorbiert werden.

14. Vorrichtung zum Messen eines Elektronenstrahlpunktes, umfassend:

ein erstes Substrat, auf dessen Oberfläche "A" eine leitende Schicht aufgetragen ist, um eine tragende Schicht zu bilden; wobei ein detektierender Kanal in der Schicht gebildet ist, welche auf einer Oberfläche "B" des ersten Substrats gegenüber der Oberfläche "A" aufgetragen ist, wobei der detektierende Kanal durch das erste Substrat verläuft und bis zur Rückseite der tragenden Schicht reicht und die Breite des detektierenden Kanals W ist;
einen auf die tragende Schicht aufgebrachten Fotolack;
ein zweites Substrat, in welchem eine rückseitige Hohlraumstruktur eigenständig ausgebildet ist, wobei die rückseitige Hohlraumstruktur dazu geeignet ist, gestreute Elektronen zu absorbieren;
Befestigungs- und Ausrichtungsmittel zum Befestigen einer Oberfläche "C" des zweiten Substrats, welche die Eingangsseite der rückseitigen Hohlraumstruktur ist, an einer Oberfläche "A" des ersten Substrats und zum Ausrichten des detektierenden Kanals mit dem Eingang der rückseitigen Hohlraumstruktur;
Abtastwinkelkontrollmittel zum Abtasten des zu messenden Elektronenstrahls über den detektierenden Kanal in einem Pfadwinkel $\theta$ in einer

Richtung, um den Fotolack in einer Rückwärtsrichtung zu belichten, wobei der Pfadwinkel ein durch die Abtastrichtung des Elektronenstrahls und die Längsrichtung des detektierenden Kanals gebildeter Neigungswinkel ist;
Messmittel zum Abmessen einer Musterlänge L des Fotolacks entlang der Abtastrichtung nach einem Entwickeln des Fotolacks und zum Berechnen des Strahlpunktdurchmessers d des Elektronenstrahls gemäss der folgenden Formel:

$$d = L \cdot \tan\theta - W/\cos\theta.$$

## Revendications

1. Procédé pour mesurer une tache d'un faisceau d'électrons, comprenant :

déposer une couche conductrice sur une surface « A » d'un premier substrat pour constituer une couche porteuse ;
former un canal détecteur sur une surface « B » du premier substrat opposée à la surface « A », dans lequel le canal détecteur traverse le premier substrat et s'étend jusqu'à la surface arrière de la couche porteuse, et la largueur du canal détecteur étant W ;
appliquer une résine photosensible sur la couche porteuse;
former une structure de cavité arrière dans un deuxième substrat qui est indépendamment traité, dans lequel la structure de cavité arrière étant configurée pour absorber des électrons diffusés ;
fixer une surface « C » du deuxième substrat par un côté d'entrée de la structure de cavité arrière à la surface « A » du premier substrat et aligner le canal détecteur avec l'entrée de la structure de cavité arrière ;
balayer le faisceau d'électrons à mesurer par le canal détecteur dans un angle de trajectoire de θ dans une direction pour exposer la résine photosensible dans une direction arrière, dans lequel l'angle de trajectoire est un angle d'inclinaison formé par la direction de balayage du faisceau d'électrons et la direction longitudinale du canal détecteur ;
développer la résine photosensible et mesurer la longueur L du motif de la résine photosensible le long de la direction de balayage ; et
calculer le diamètre d de la tâche du faisceau d'électrons selon la formule suivante : $d = L \cdot \tan\theta - W/\cos\theta.$

2. Procédé selon la revendication 1, dans lequel le procédé comprend en outre une application d'une couche protectrice sur la résine photosensible après une application de la résine photosensible et un enlèvement de la couche protectrice avant un développement de la résine photosensible.

3. Procédé selon la revendication 2, dans lequel la couche protectrice comprend un polymère comme un polyimide ou un alcool polyvinylique.

4. Procédé selon l'une des revendications 1 à 3, dans lequel la structure de cavité arrière et la couche protectrice constituent une structure absorbante pour absorber la plupart des électrons diffuses.

5. Procédé selon l'une des revendications 1 à 4, dans lequel la structure de cavité arrière est une cavité arrière traversante ou non-traversante, qui est formée indépendamment dans le deuxième substrat.

6. Procédé selon l'une des revendications 1 à 5, dans lequel la section transversale de la structure de cavité arrière est d'une forme approximative ronde, cunéiforme ou rectangulaire.

7. Procédé selon la revendication 6, dans lequel la taille de l'entrée de la cavité arrière avec une forme approximative ronde ou cunéiforme étant plus grande ou égale à celle du canal détecteur, la taille d'entrée de la cavité arrière avec une forme rectangulaire étant plus grande que celle du canal détecteur, et la cavité arrière formée étant beaucoup plus grande que l'ouverture du canal détecteur.

8. Procédé selon la revendication 6 ou 7, dans lequel la structure de cavité arrière avec une forme appropriée ronde, cunéiforme ou rectangulaire est formé par un processus d'usinage ou de gravure depuis une surface D du deuxième substrat et prolonge le deuxième substrat jusqu'à la surface « C » ; ou la structure de cavité arrière avec une forme appropriée ronde ou rectangulaire étant formée par un procédé d'usinage ou de gravure de la surface « C » du deuxième substrat et forme une structure de cavité arrière non-traversante.

9. Procédé selon l'une des revendications 1 à 8, dans lequel la couche porteuse étant une couche conductrice ayant une section transversale de diffusion plus petite pour le faisceau d'électrons mesuré.

10. Procédé selon l'une des revendications 1 à 9, dans lequel la couche porteuse étant une couche d'aluminium ou une couche de silicium avec une épaisseur inférieure à 50 nm, et pour la couche de silicium le Si/SiO$_2$ étant déposé en premier et ensuite le SiO$_2$ étant enlevé après que le canal détecteur est accompli.

11. Procédé selon l'une des revendications 1 à 10, dans lequel une largeur du canal détecteur est d'environ 0,5 à 1,5 μm.

12. Procédé selon l'une des revendications 1 à 11, dans lequel l'étape de fixation comprend une fixation mécanique ou une fixation par collage.

13. Procédé selon l'une des revendications 1 à 12, dans lequel un rapport d'aspect du canal détecteur est suffisamment haut pour former un canal fin pénétrant au travers du premier substrat, de sorte que la plupart des électrons diffusés générés aux bords du canal détecteur sont absorbés par les parois latérales.

14. Dispositif pour mesurer une tache d'un faisceau d'électrons, comprenant:

une surface « A » d'un premier substrat sur laquelle une couche conductrice est déposée pour constituer une couche porteuse ; dans lequel un canal détecteur est formé sur la couche déposée sur une surface « B » du premier substrat opposé à la surface « A », dans lequel le canal détecteur s'étend au travers du premier substrat et s'étend jusqu'à la surface arrière de la couche porteuse, et la largeur du canal détecteur étant W ;
une résine photosensible appliquée sur la couche de support ;
un deuxième substrat dans lequel une structure de cavité arrière étant formée indépendamment, la structure de cavité arrière étant configurée pour absorber des électrons diffusés ;
des moyens de fixation et d'alignement pour fixer une surface « C » du deuxième substrat qui est le côté d'entrée de la cavité arrière avec la surface « A » du premier substrat, et pour aligner le canal détecteur avec l'entrée de la structure de cavité arrière ;
des moyens de contrôle de l'angle de balayage pour balayer le faisceau d'électrons à mesurer au travers le canal détecteur dans un angle de trajectoire θ dans une direction pour exposer la résine photosensible dans une direction arrière, dans lequel l'angle de trajectoire étant un angle d'inclinaison formé par la direction de balayage du faisceau d'électrons et la direction longitudinale du canal détecteur ;

des moyens de mesure pour mesurer la longueur L du motif de la résine photosensible le long de la direction de balayage après un développement de la résine photosensible, et calculer le diamètre d de la tâche du faisceau d'électrons selon la formule suivante :

$$d = L \cdot \tan\theta - W / \cos\theta.$$

Electron beam
Detecting channel
Projection boundary
Supporting film
Photoresist
Back cavity structure
Exposure boundary
Electron beam spot
Path angle
$\theta$

(a) (b)

fig.1

Electron beam
Detecting channel
Projection boundary
Supporting film
Photoresist
Protective layer
Back cavity structure
Exposure boundary
Electron beam spot
Path angle
$\theta$

(a) (b)

fig.2

Electron-optic system

Focused electron beam

Detecting device

Sample holder

fig.3

$t$

$d$

$T$

$L$

$\theta$

$W$

fig.4

Electron beam

Detecting channel

Supporting film

Photoresist

Back cavity structure

fig.5（a）

Electron beam

Detecting channel

Supporting film

Photoresist

Back cavity structure

fig.5（b）

fig.6 （a）

fig.6 （b）

```
                        ┌──────────────────────┐
                        │        start         │
                        └──────────────────────┘

S701                                              S702
┌──────────────────────────────────┐   ┌──────────────────────────────────┐
│ forming a suspended photoresist   │   │ preparing a second substrate by   │
│ layer on the first substrate and  │   │ forming a back cavity structure   │
│ forming a detecting channel on    │   │ in the second substrate which is  │
│ another side of the first         │   │ independently processed           │
│ substrate opposite to the         │   │                                   │
│ photoresist layer                 │   │                                   │
└──────────────────────────────────┘   └──────────────────────────────────┘

                  ┌──────────────────────────────────┐
S703              │ fixing back cavity entrance side  │
                  │ of the second substrate to the    │
                  │ photoresist side of the first     │
                  │ substrate and aligning the        │
                  │ detecting channel with the        │
                  │ entrance of the back cavity       │
                  │ structure                         │
                  └──────────────────────────────────┘

                  ┌──────────────────────────────────┐
S704              │ scanning the electron beam to be  │
                  │ measured across the detecting     │
                  │ channel in a path angle of θ in   │
                  │ one direction to expose the       │
                  │ photoresist in a backwards        │
                  │ direction                         │
                  └──────────────────────────────────┘

                  ┌──────────────────────────────────┐
S705              │ developing the photoresist and    │
                  │ measuring a pattern length L of   │
                  │ the photoresist along the         │
                  │ scanning direction and            │
                  │ calculating the beam spot         │
                  │ diameter d of the electron beam   │
                  │ according to formula              │
                  └──────────────────────────────────┘

                        ┌──────────────────────┐
                        │         end          │
                        └──────────────────────┘
```

fig.7

```
                              ┌──────────────┐
              ┌───────────────│    start     │───────────────┐
              │               └──────────────┘               │
              │                                               │
S801          ▼                                     S804      ▼
┌─────────────────────────────────┐        ┌─────────────────────────────────┐
│ depositing a conductive film on  │        │ forming a back cavity structure  │
│ "A" surface of a first           │        │ in a second substrate            │
│ substrate to constitute a        │        │ which is independently processed │
│ supporting film                  │        └─────────────────────────────────┘
└─────────────────────────────────┘                         │
              │                                              │
S802          ▼                                              │
┌─────────────────────────────────┐                         │
│ forming a detecting channel on   │                         │
│ "B" surface of the first         │                         │
│ substrate opposite to the "A"    │                         │
│ surface                          │                         │
└─────────────────────────────────┘                         │
              │                                              │
S803          ▼                                              │
┌─────────────────────────────────┐                         │
│ applying photoresist on the      │                         │
│ supporting film                  │                         │
└─────────────────────────────────┘                         │
              │                                              │
              │        ┌──────────────────────────────────┐ │
              │        │ fixing "C" surface of the second  │ │
              └───────▶│ substrate which is the entrance   │◀┘
                       │ side of the back cavity structure │
                       │ to the "A" surface of the first   │
                       │ substrate and aligning the        │
              S805     │ detecting channel with the        │
                       │ entrance of the back cavity       │
                       │ structure                         │
                       └──────────────────────────────────┘
                                      │
              S806                    ▼
                       ┌──────────────────────────────────┐
                       │ scanning the electron beam to be  │
                       │ measured across the detecting     │
                       │ channel in a path angle of θ in   │
                       │ one direction to expose the       │
                       │ photoresist in backwards direction│
                       └──────────────────────────────────┘
                                      │
              S807                    ▼
                       ┌──────────────────────────────────┐
                       │ developing the photoresist and    │
                       │ measuring pattern length L of the │
                       │ photoresist along the scanning    │
                       │ direction, and calculating the    │
                       │ beam spot diameter d of the       │
                       │ electron beam according to formula│
                       └──────────────────────────────────┘
                                      │
                                      ▼
                               ┌──────────────┐
                               │     end      │
                               └──────────────┘
```

fig.8

start

S901 · depositing a conductive film on an "A" surface of a first substrate to constitute a supporting film

S905 · forming a back cavity structure in a second substrate which is independently processed

S902 · forming a detecting channel on a "B" surface of the first substrate opposite to the "A" surface

S903 · applying photoresist on the supporting film

S904 · applying a protective layer on the photoresist

S906 · fixing "C" surface of the second substrate which is the entrance side of the back cavity structure to the "A" surface of the first substrate and aligning the detecting channel with the entrance of the back cavity structure

S907 · scanning the electron beam to be measured across the detecting channel in a path angle of θ in one direction to expose the photoresist in a backwards direction

S908 · removing the protective layer

S909 · developing the photoresist and measuring a pattern length L of the photoresist along the scanning direction, and calculating the beam spot diameter d of the electron beam according to formula

end

fig.9

Detecting channel

Supporting film

Photoresist

Protective layer

Back cavity structure

fig. 10

First substrate

fig. 11 (a)

fig. 11 (b)

fig. 11 (c)

Second substrate

fig. 11 (d)

First substrate

Second substrate

fig. 11(e)

First substrate

fig. 11(f)

First substrate

fig. 12(a)

fig. 12(b)

fig. 12(c)

fig. 12(d)

fig. 12(e)

fig. 12(f)

fig. 12(g)